# EUROPÄISCHE PATENTSCHRIFT

(11) **EP 3 156 588 B1**
(45) Veröffentlichungstag und Bekanntmachung des Hinweises auf die Patenterteilung: **05.08.2020**
(21) Anmeldenummer: 16183282.9
(22) Anmeldetag: 09.08.2016
(51) Int. Cl.: B23K 101/00, C30B 13/22, C30B 29/52, B23P 6/00, C30B 13/24, F01D 5/00

(54) **REPARATURVERFAHREN FÜR DICHTSEGMENTE**
REPAIR METHOD FOR SEAL SEGMENTS
PROCEDE DE REPARATION D'ELEMENTS D'ETANCHEITE

(30) Priorität: 08.10.2015 DE 102015219513
(43) Veröffentlichungstag der Anmeldung: 19.04.2017
(73) Patentinhaber: MTU Aero Engines AG, 80995 München (DE)
(72) Erfinder: Schulze, Uwe, 29308 Winsen (DE); Partes, Knut, Verden 27283 (DE)

(56) Entgegenhaltungen:
- EP-A1- 1 798 316
- EP-A1- 2 078 587
- WO-A1-03/087439

## Beschreibung

### GEBIET DER ERFINDUNG

Die vorliegende Erfindung betrifft ein Verfahren zur Reparatur von zumindest teilweise einkristallin ausgebildeten Dichtsegmenten einer Strömungskanalbegrenzung einer Strömungsmaschine.

### STAND DER TECHNIK

Bei Strömungsmaschinen, wie stationären Gasturbinen oder Flugzeugtriebwerken, dreht sich ein Rotor in Form einer sich drehenden Welle mit einer Vielzahl von Laufschaufeln gegenüber einem Stator, der durch das umgebende Gehäuse und daran angeordnete Leitschaufeln gebildet ist. Um einen hohen Wirkungsgrad zu erzielen, soll möglichst das gesamte, die Maschine durchströmende Arbeitsgas den vorgesehenen Strömungspfad zwischen den Leitschaufeln und den Laufschaufeln durchströmen. Entsprechend soll vermieden werden, dass an den freien Enden der Leit- bzw. Laufschaufeln und den gegenüberliegenden, sich relativ dazu bewegenden Maschinenteilen Arbeitsgas vorbeiströmen kann. Entsprechend ist es bekannt, zwischen den jeweiligen Komponenten Dichtungen vorzusehen, und zwar in Form der sogenannten Outer - Air - Seal (äußere Luftdichtung) oder Inner - Air - Seal (innere Luftdichtung), so dass unter allen Betriebsbedingungen möglichst keine Strömungsverluste an Arbeitsgas im Bereich der freien Enden von Leit- bzw. Laufschaufeln auftreten. Hierzu werden im Stand der Technik Panzerungen bzw. sogenannte Dichtfinnen zusammen mit Einlaufbelägen vorgesehen, in welche sich die Panzerungen bzw. Dichtfinnen einschleifen können, damit auch bei Veränderung der Zwischenräume zwischen den freien Enden von Leit- und Laufschaufeln und den gegenüberliegenden Maschinenkomponenten während unterschiedlicher Betriebsbedingungen die Strömungsverluste möglichst gering gehalten werden.

Die Outer - Air - Seal ist üblicherweise an sogenannten Dichtsegementen der inneren Hülle des Gehäuses angeordnet, wobei die Dichtsegmente häufig aus einem einkristallinen Werkstoff gebildet sind, um durch die einkristalline Ausgestaltung des Bauteils eine bessere Hochtemperaturfestigkeit zu erzielen. Mehrere Dichtsegmente des Gehäuses bzw. einer inneren Hülle des Gehäuses können hinereinander umlaufend um die Drehachse der Strömungsmaschine und axial nebeneinander angeordnet sein, um die innere Begrenzung des Strömungskanals zu bilden.

Durch die hohen thermischen und mechanischen Belastungen der Dichtsegmente können Schädigungen durch Poren und Risse auftreten, die nicht nur in einem Einlaufbelag der Dichtsegmente, sonderen auch im Grundmaterial der Dichtsegmente auftreten können. Sofern die Poren und Risse die Strukturfestigkeit der Dichtsegemente bedrohen bzw. wenn der Einlaufbelag durch Einschleifen der passierenden Laufschaufeln verschlissen ist, müssen die entsprechenden Dichtsegmente mit den Einlaufbelägen ausgewechselt werden, was einen hohen Aufwand und einen Materialverlust bedeuten kann.

Aus der Patentanmeldungsveröffentlichung EP 2 078 587 A1 ist ein Verfahren zur Reparatur von Dichtsegmenten einer Turbine bekannt, bei welchem der verschlissene Einlaufbelag zunächst entfernt wird und anschließend ein neuer Einlaufbelag, der in einem Gussverfahren hergestellt wurde, mittels Diffusionsschweißen auf dem Grundmaterial befestigt wird. Aus der Patentanmeldungsveröffentlichung WO 03/087439 A1 ist ein Verfahren zur Regeneration verschlissener Turbinenschaufeln bekannt, bei welchem Material mittels eines Lasers oder Elektronenstrahls epitaktisch auf der verschlissenen Turbinenschaufel aufgetragen wird. Aus der Patentanmeldungsveröffentlichung EP 1 798 316 A1 schließlich ist ein Verfahren zur Reparatur von Turbinenkomponenten bekannt, bei welchem ein in bestimmter Form vorliegendes Reparaturmaterial mittels Diffusionsschweißen auf dem Grundmaterial befestigt wird, wobei ein epitaktischer Gefügeverbund erreicht wird.

### OFFENBARUNG DER ERFINDUNG

### AUFGABE DER ERFINDUNG

Es ist deshalb Aufgabe der vorliegenden Erfindung, ein Reparaturverfahren zu schaffen, mit dem Dichtsegmente von Strömungsmaschinen, wie stationären Gasturbinen oder Flugtriebwerken, zuverlässig repariert werden können, wobei die reparierten Dichtsegmente eine möglichst lange Lebensdauer aufweisen sollen. Gleichzeitig soll das Reparaturverfahren einfach und zuverlässig durchführbar sein.

### TECHNISCHE LÖSUNG

Diese Aufgabe wird gelöst durch ein Reparaturverfahren mit den Merkmalen des Anspruchs 1. Vorteilhafte Ausgestaltungen sind Gegenstand der abhängigen Ansprüche.

Die Erfindung schlägt ein Reparaturverfahren vor, bei dem zumindest teilweise einkristallin ausgebildete Dichtsegmente einer Strömungskanalbegrenzung einer Strömungsmaschine in einem bestimmten, vordefinierten Reparaturbereich repariert und aufgearbeitet werden. Durch den vorbestimmten und definierten Reparaturbereich, der möglichst für alle gleichen oder gleichartigen Dichtsegmente gleich festgelegt wird, kann eine hohe Prozesssicherheit und eine Vermeidung von Reparaturfehlem erreicht werden. Dies gilt insbesondere deshalb, weil der Reparaturbereich nicht auf einzelne, zu identifizierende Defekte beschränkt wird, sondern abhängig von der Geometrie und der Form des Dichtsegments generell für alle gleichen oder gleichartigen Dichtsegmente festgelegt wird. Der Reparaturbereich geht somit über die tatsächlich vorhandenen Defekte hinaus.

Anschließend wird in dem definierten Reparaturbereich ein Teil des Grundmaterials des Dichtsegments entfernt und nachfolgend wird in dem Reparaturbereich eine Reparaturbeschichtung epitaktisch auf dem einkristallinen Grundmaterial aufgebaut, sodass durch die Reparaturbeschichtung das einkristallinen Material des Grundmaterials epitaktisch ersetzt wird. Entsprechend ist unter zumindest teilweise einkristallin ausgebildeten Dichtsegmenten zu verstehen, dass zumindest das Material des Grundkörpers des Dichtsegments bzw. das Grundmaterial einkristallin ausgebildet ist, während ein möglicher Einlaufbelag auf dem Dichtsegment nicht einkristallin ausgebildet sein muss.

Durch das epitaktische Ausbilden einer Reparaturbeschichtung auf dem Grundmaterial kann erreicht werden, dass gleiche oder zumindest ähnliche Eigenschaften des Materials in der Reparaturbeschichtung vorliegen, wie diejenigen des Grundmaterials. Zwar ist das epitaktische Reparieren von einkristallinen Werkstücken und insbesondere Turbinenschaufeln bereits aus dem Stand der Technik bekannt (siehe EP 0 892 090 A1, EP 2 501 876 A1 oder US 2011/0052386A1), allerdings werden bei den dort beschriebenen Reparaturverfahren, die für andere Bauteile als Dichtsegmente eingesetzt worden sind, nur lokal geschädigte Bereich repariert, was im Falle von Dichtsegmenten zum Verzug der Bauteile aufgrund der großflächigen und dünnen Ausführung der Dichtsegmente führen kann. Darüber hinaus sind deratige Verfahren mit der Identifizierung der lokal vorliegenden Defekte sehr aufwändig und bergen die Gefahr, dass nicht sämtliche Defekte repariert werden. Durch das erfindungsgemäße Definieren eines Reparaturbereichs, der so definiert wird, dass ohne konkrete Identifizierung der lokalen Defekte davon ausgegangen wird, dass in diesem Bereich die höchste Wahrscheinlichkeit für Defekte vorliegt, kann eine gleichmäßige Reparatur der großflächigen Dichtsegmente mit einer hohen Prozessstabilität durchgeführt werden.

Der Reparaturbereich kann beispielsweise durch den Laufschaufellaufbereich des Dichtsegments definiert werden, der wiederum dadurch definiert ist, dass in dem Laufschaufellaufbereich die gegenüberliegenden Laufschaufeln der Strömungsmaschine während des Betriebs der Strömungsmaschine das Dichtsegment passieren oder zumindest bei gedachter radialer Verlängerung der Laufschaufeln das Dichtsegment bzw. den Einlaufbelag streifen. Ein derartiger Reparaturbereich kann über den Laufschaufellaufbereich ausgedehnt werden, um an den Rändern einen gewissen Sicherheitsbereich vorzusehen. Beispielsweise kann der Reparaturbereich den Laufschaufellaufbereich um max. 20 Prozent, vorzugsweise um max. 10 Prozent der Erstreckung des Laufschaufellaufbereichs in der Richtung überschreiten, in der der Reparaturbereich über den Laufschaufelbereich ausgedehnt wird.

Die Entfernung von Material von dem Dichtsegment kann durch mechanische Bearbeitung und insbesondere spanabhebende Bearbeitung wie Schleifen, Drehen oder Fräsen erfolgen, wobei dies sowohl für die Entfernung einer auf dem Grundmaterial des Dichtsegments vorgesehenen Beschichtung, z. B. eines Einlaufbelags, wie für das Grundmaterial gilt.

Das Grundmaterial kann so weit im Reparaturbereich entfernt werden, dass keine Poren oder Risse mehr im Reparaturbereich zu erfassen sind. Dies kann durch visuelle Inspektion oder durch entsprechende Prüfverfahren während der Bearbeitung oder zwischen einzelnen Bearbeitungsschritten festgestellt werden. Lediglich Risse oder Poren mit einem Durchmesser oder einer maximalen Erstreckung die kleiner oder gleich einem Grenzwert sind, können in dem Grundmaterial verbleiben, da beim epitaktischen Aufwachsen einer Reparaturbeschichtung derartige Fehlstellen ausgeheilt werden können. Üblicherweise kann der Grenzwert so gewählt werden, dass dieser dem Durchmesser oder der maximalen Erstreckung entspricht, die bei einem neuen Bauteil nach dem Abgießen des Werkstoffs toleriert werden.

Die Reparaturbeschichtung kann aus dem identischen Material gebildet werden, welches als Grundmaterial den Grundkörper des Dichtsegments bildet. Alternativ können auch ähnliche Materialen eingesetzt werden, die insbesondere dieselbe Gitterstruktur mit ähnlichen Gitterkonstanten aufweisen, sodass ein nahezu einkristalliner Verbund zwischen Grundmaterial und Reparaturbeschichtung möglich ist. Die Reparaturbeschichtung kann aus mehreren, auch unterschiedlichen Teilschichten aufgebaut sein und insbesondere durch generative Verfahren wie Auftragsschweißen oder Elektronenstrahlschweißen gebildet werden.

Die Reparaturbeschichtung kann mit Übermaß aufgebracht werden, da nach dem Aufbringen der Reparaturbeschichtung diese einer mechanischen Formgebung, beispielsweise durch spanabhebende Bearbeitung, unterzogen werden kann.

### KURZBESCHREIBUNG DER FIGUREN

Die beigefügten Zeichnungen zeigen in rein schematischer Weise in
- Fig. 1: einen teilweisen Schnitt durch eine Strömungsmaschine mit einem Leit- und Laufschaufelpaar,
- Fig. 2: einen Querschnitt durch ein Dichtsegment,
- Figur 3: eine Draufsicht auf ein Dichtsegment und in
- Figur 4: in den Teilbildern a) bis f) die verschiedenden Verfahrensschritte eines Ausführungsbeispiels des erfindungsgemäßen Reparaturverfahrens.

Weitere Vorteile, Kennzeichen und Merkmale der vorliegenden Erfindung werden bei der nachfolgenden detaillierten Darstellung von Ausführungsbeispielen deutlich. Allerdings ist die Erfindung nicht auf diese Ausführungsbeispiele beschränkt.

### AUSFÜHRUNGSBEISPIELE

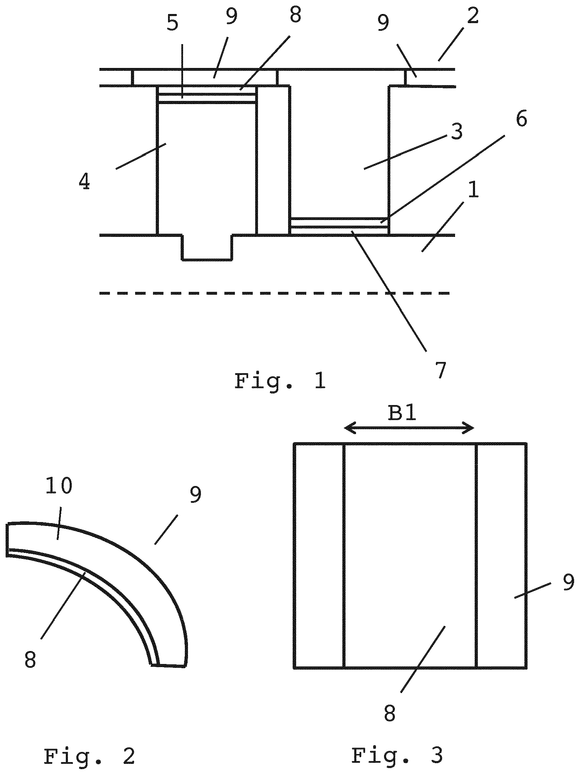

Die Fig. 1 zeigt einen teilweisen Schnitt durch eine Strömungsmaschine, wie beispielsweise ein Flugzeugtriebwerk, mit einer Welle 1, welche von einem Gehäuse 2 ringförmig umgeben ist, wobei jedoch in der Fig. 1 lediglich ein Teil oberhalb der gestrichelt dargestellten Symmetrielinie bzw. Drehachse der Welle 1 gezeigt ist. An der Welle 1 sind eine Vielzahl von Laufschaufeln 4 umlaufend um die Welle 1 nebeneinander in einer Laufschaufelreihe sowie in mehreren Laufschaufelreihen angeordnet, wobei in der Fig. 1 lediglich eine Laufschaufelreihe mit einer Laufschaufel 4 gezeigt ist. Benachbart zu der Laufschaufel 4 ist eine Leitschaufel 3 angeordnet, die an dem Gehäuse 2 befestigt ist, wobei wiederum in mehreren Laufschaufelreihen jeweils mehrere Laufschaufeln umlaufend um die Drehachse nebeneinander angeordnet sind. Die Leitschaufeln 3 sind ortsfest mit dem Gehäuse 2 verbunden, während sich die Laufschaufeln 4 bei Drehung der Welle 1 mit dieser drehen.

Das Gehäuse 2, welches in der stark vereinfachten Darstellung der Fig. 1 eine zylindrische Grundform aufweist, kann aus einer Vielzahl von Bauteilen und insbesondere aus einer äußeren und inneren Hülle aufgebaut sein. Die Komponenten der inneren Hülle, die hohen Temperaturen durch das vorbeiströmende Gas ausgesetzt sind, können zumindest teilweise aus einkristallinem Material gebildet sein, um so ausreichende Festigkeit bei hohen Temperaturen bereitzustellen.

Das Gehäuse 2 kann mehrere Dichtsegmente 9 aufweisen, die als Gehäusebauteile hintereinander umlaufend um die Drehachse der Strömungsmaschine und nebeneinander in axialer Richtung angeordnet sein können. In Fig. 1 sind der Einfachheit halber lediglich Querschnitte von einigen wenigen Segmenten 9 zu sehen.

Um Strömungsverluste zwischen Gehäuse 2 und den Spitzen der Laufschaufeln 4 einerseits sowie den freien Enden der Leitschaufeln 3 und der Welle 1 andererseits zu vermeiden, sind in diesen Bereichen sogenannte Dichtungen angeordnet, und zwar einerseits eine sogenannte Outer - Air - Seal im Bereich der Spitzen der Laufschaufeln 4 und eine Inner - Air - Seal im Bereich der freien Enden der Leitschaufeln 3. Die Outer - Air - Seal ist an einem entsprechenden Dichtsegment 9 angeordnet.

Die Dichtungen bestehen jeweils aus aufeinander abgestimmter Dichtungspaare, beispielsweise einer Spitzenpanzerung 5 an den freien Enden der Laufschaufeln 4 mit einem sogenannten Einlaufbelag 8, welcher gegenüberliegend den freien Enden der Laufschaufeln 4 am Dichtsegment 9 des Gehäuses 2 angeordnet ist.

Da sich der Spalt zwischen den freien Enden der Laufschaufeln 4 und dem Gehäuse 2 je nach Betriebsbedingungen ändern kann, wird die entsprechende Dichtung so ausgelegt, dass die Spitzenpanzerung 5 den Einlaufbelag 8 anschleift bzw. sich in diesen einschleift, um eine optimale Dichtung zu gewährleisten. Entsprechend können an der Spitzenpanzerung 5 sogenannte Dichtfinnen (nicht gezeigt) vorgesehen sein, die jeweils als hervorstehende Stege ausgebildet sind und definierte Nuten in den Einlaufbelag 8 einschleifen.

Entsprechend kann auch an der sogenannten Inner - Air - Seal eine Panzerung 6 mit einem Einlaufbelag 7 vorgesehen sein, wobei die Anordnung von Panzerung 6 und Einlaufbelag 7 an dem Rotor, d. h. der Welle 1, oder dem Stator, d. h. der Leitschaufel 3, beliebig erfolgen kann. Dies gilt auch für die Outer - Air - Seal - Dichtung.

Die Figur 2 zeigt ein Dichtesegment 9 im Querschnitt. Das Dichtsegment 9 weist einen Körper aus einem Grundmaterial 10 auf, auf dem der Einlaufbelag 8 angeordnet ist. Die Figur 3 zeigt das Dichtsegment 9 in einer Draufsicht.

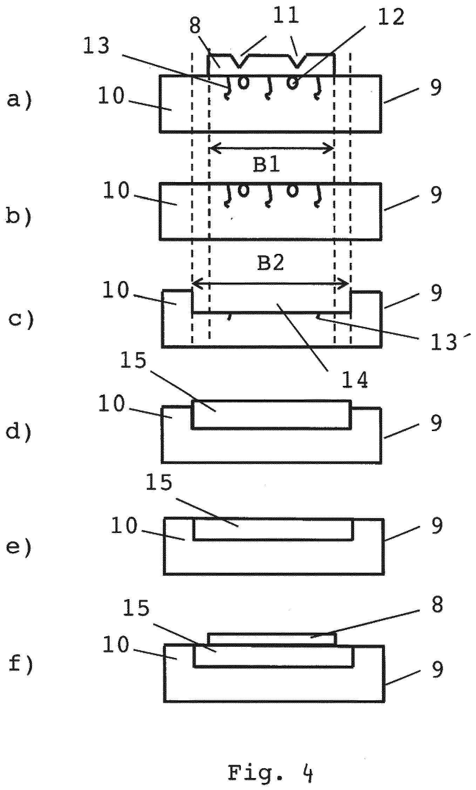

In der Figur 4 ist das Dichtsegment im Querschnitt gezeigt, wobei in den Teilbildern a) bis f) die verschiedenen Reparaturschritte des erfindungsgemäßen Reparaturverfahrens gezeigt sind. In Teilbild a) der Figur 4 ist der Ausgangszustand eines gebrauchten Dichtsegments 9 zu sehen, bei dem im Einlaufbelag 8 zwei Nuten 11 eingeschliffen sind, die beispielsweise von Dichtfinnen einer entsprechenden Laufschaufel 4 stammen.

Durch die Temparaturbelastung des Dichtsegments während des Betriebs und die sich daraus ergebenden Diffusionsvorgänge innerhalb des Materials haben sich Poren 12 ausgebildet, die sowohl im Einlaufbelag 8 als auch im Grundmaterial 10 vorliegen können. Darüber hinaus hat sich durch die thermische-mechanische Belastung des Dichtsegments 9 eine Schädigung durch Risse 13 ergeben, die ebenfalls sowohl im Einlaufbelag 8 als auch im Grundmaterial 10 vorliegen kann. Bei dem in Figur 3 und 4 gezeigten Dichtsegment 9 entspricht die Breite B1 des Einlaufbelags 8 dem Laufschaufellaufbereich, der durch die passierenden oder anschleifenden Laufschaufeln 4 an dem Dichtsegment definiert wird.

Im Teilbild b) der Figur 4 ist der Zustand nach dem Entfernen des Einlaufbelags 8 gezeigt. Der Einlaufbelag 8 kann von dem Dichtsegment 9 beispielsweise abgeschliffen oder abgefräst werden.

Zusätzlich wird in einem Reparaturbereich, welcher die Breite B2 aufweist, die größer ist als die Breite B1 des Einlaufbelags 8 bzw. des Laufschaufellaufbereichs, Grundmaterial 10 entfernt, wobei wiederum geeignete mechanische Bearbeitungsverfahren wie Fräsen oder Schleifen eingesetzt werden können.

In dem Reparaturbereich 14 wird so viel Grundmaterial 10 entfernt, dass möglichst sämtliche Poren 12 und Risse 13 entfernt sind. Lediglich klein dimensionierte Reste von Rissen 13 und/oder Poren (nicht gezeigt), die durch die nachfolgende epitaktische Abscheidung einer Reparaturbeschichtung 15 auf das einkristalline Grundmaterial 10 ausgeheilt werden können, können in dem Grundmaterial 10 verbleiben, wie in der Figur 4 c) gezeigt ist.

Nach dem Entfernen des Einlaufbelags 8 und des Grundmaterials 10 im Reparaturbereich 14 wird in diesem Bereich eine Reparaturbeschichtung 15 durch ein generatives Verfahren, wie beispielsweise Auftragsschweißen, aufgebracht, wobei die Aufbringung so erfolgt, dass das Material der Reparaturbeschichtung 15 epitaktisch auf dem einkristallinen Grundmaterial 10 aufwächst, sodass bei der Verwendung desselben Materials wie das Grundmaterial 10 für die Reparaturbeschichtung 15 ein einkristalliner Körper entsteht. Bei Verwendung eines zum Grundmaterial 10 unterschiedlichen Materials für die Reparaturbeschichtung 15 wird ein Material gewählt, welches eine ähnliche Gitterstruktur und ähnliche Gitterkonstanten aufweist, sodass durch das epitaktische Aufwachsen eine quasi-einkristalline Struktur gebildet werden kann.

Wie in Teilbild d) der Figur 4 zu erkennen ist, kann die Reparaturbeschichtung 15 im Übermaß aufgebracht werden, da nachfolgend eine mechanische Formgebung der Reparaturbeschichtung 15 erfolgt, bei der überschüssiges Material der Reparaturbeschichtung 15 durch spanabhebende Bearbeitung entfernt wird. Das entsprechende Resultat ist in Teilbild e) der Figur 4 dargestellt. Auf einem entsprechend reparierten Grundkörper des Dichtsegments 9 kann wiederum ein Einlaufbelag 8 vorgesehen werden, wie es in Teilbild f) der Figur 4 dargestellt ist, sodass nach der Reparatur ein vollständig neues Dichtsegment 9 mit Einlaufbelag 8 vorliegt, welches in der Strömungsmaschine wieder eingesetzt werden kann.

Obwohl die vorliegende Erfindung anhand des Ausführungsbeispiels detailliert beschrieben worden ist, ist für den Fachmann selbstverständlich, dass die Erfindung nicht auf dieses Ausführungsbeispiel beschränkt ist, sondern dass vielmehr Abwandlungen in der Weise möglich sind, dass Einzelmerkmale weggelassen oder andersartige Kombinationen von Merkmalen verwirklicht werden können, solange der Schutzbereich der beigefügten Ansprüche nicht verlassen wird. Darüber hinaus sind sämtliche Kombinationen der vorgestellten Einzelmerkmale Gegenstand der vorliegenden Offenbarung.

### DEFINITIONEN

Unter axialer und radialer Richtung wird in der vorliegenden Beschreibung Bezug genommen auf die Drehachse der Strömungsmaschine, sodass unter einer axialen Richtung die Richtung verstanden wird, in der sich die Drehachse der Strömungsmaschine erstreckt, während unter einer radialen Richtung die Richtung verstanden wird, die sich von der Drehachse weg erstreckt.

### BEZUGSZEICHENLISTE

- 1: Welle
- 2: Gehäuse
- 3: Leitschaufel
- 4: Laufschaufel
- 5: Panzerung
- 6: Panzerung
- 7: Einlaufbelag
- 8: Einlaufbelag
- 9: Dichtsegment
- 10: Grundmaterial bzw. Grundkörper
- 11: Einlaufenut
- 12: Pore
- 13: Riss
- 14: Reparaturbereich
- 15: Reparaturbeschichtung

## Patentansprüche

1. Verfahren zur Reparatur von zumindest teilweise einkristallin ausgebildeten Dichtsegmenten (9) einer Strömungskanalbegrenzung (2) einer Strömungsmaschine, bei welchem zunächst ein Reparaturbereich (14) des Dichtsegments festgelegt wird,
der unabhängig von vorhandenen Defekten (12,13) ohne Identifizierung der lokalen Defekte festgelegt wird, sodass der Reparaturbereich nicht auf einzelne, zu identifizierende Defekte beschränkt ist, wobei
der Reparaturbereich (14) durch einen Laufschaufellaufbereich des Dichtsegments (9) definiert wird, den eine Laufschaufel (4) der Strömungsmaschine während des Betriebs der Strömungsmaschine passiert oder zumindest bei gedachter radialer Verlängerung der Laufschaufel streift
**dadurch gekennzeichnet, dass**
anschließend ein Teil eines Grundmaterials (10) des Dichtsegments (9) im Reparaturbereich (14) entfernt wird, wobei nachfolgend in dem Reparaturbereich eine Reparaturbeschichtung (15) epitaktisch abgeschieden wird, wobei
die Reparaturbeschichtung (15) mit einem Übermaß aufgebracht und nach dem Aufbringen mechanisch, insbesondere spanabhebend, geformt wird.

2. Verfahren nach Anspruch 1,
**dadurch gekennzeichnet, dass**
der Reparaturbereich (14) sich über den Laufschaufellaufbereich erstreckt, wobei der Reparaturbereich an jeder Seite, an der der Reparaturbereich den Laufschaufelbereich überschreitet, den Laufschaufellaufbereich um maximal 20%, vorzugsweise maximal 10 % der Erstreckung des Laufschaufellaufbereichs in einer Richtung, die der Richtung entspricht, über die der Reparaturbereich über den Laufschaufelbereich erweitert wird, überschreitet.

3. Verfahren nach einem der vorhergehenden Ansprüche,
**dadurch gekennzeichnet, dass**
eine im Reparaturbereich (14) vorgesehene Beschichtung (8) auf dem Grundmaterial des Dichtsegments vor der Entfernung eines Teils des Grundmaterials (10) im Reparaturbereich entfernt wird.

4. Verfahren nach einem der vorhergehenden Ansprüche,
**dadurch gekennzeichnet, dass**
die Entfernung von Material mechanisch durch Schleifen und/oder Fräsen erfolgt.

5. Verfahren nach einem der vorhergehenden Ansprüche,
**dadurch gekennzeichnet, dass**
die Entfernung von Grundmaterial (10) des Dichtsegments (9) soweit erfolgt, dass im Reparaturbereich im Grundmaterial keine Risse (13) oder Poren (12) oder nur Risse oder Poren mit einem Durchmesser oder einer maximalen Erstreckung kleiner oder gleich einem Grenzwert gemäß zulässiger Toleranzen eines neuen Dichtsegments enthalten sind.

6. Verfahren nach einem der vorhergehenden Ansprüche,
**dadurch gekennzeichnet, dass**
die Reparaturbeschichtung (15) aus einem von Grundmaterial (10) unterschiedlichen Reparaturmaterial und/oder einem zu Grundmaterial identischen Reparaturmaterial gebildet wird.

7. Verfahren nach einem der vorhergehenden Ansprüche,
**dadurch gekennzeichnet, dass**
die Reparaturbeschichtung (15) aus mehreren Teilschichten aufgebaut ist.

8. Verfahren nach einem der vorhergehenden Ansprüche,
**dadurch gekennzeichnet, dass**
die Reparaturbeschichtung (15) durch generative Verfahren, insbesondere durch Auftragsschweißen mittels hochenergetischer Strahlen, insbesondere Laserstrahlen oder Elektronenstrahlen aufgebracht wird.

## Claims

1. Method for repairing at least partly monocrystalline sealing segments (9) of a flow channel boundary (2) of a turbomachine, in which method initially a repair region (14) of the sealing segment is defined, which region is determined independently of existing defects (12, 13) without identifying the local defects such that the repair region is not restricted to individual defects to be identified, the repair region (14) being defined by a rotor blade running region of the sealing segment (9) which a rotor blade (4) of the turbomachine passes during operation of the turbomachine or which said blade grazes at least in an imaginary radial extension of the rotor blade, **characterized in that** part of a base material (10) of the sealing segment (9) in then removed in the repair region (14), with a repair coating (15) subsequently being deposited epitaxially in the repair region, the repair coating (15) being applied in an excessive amount and, after the application, being mechanically shaped, in particular by machining.

2. Method according to claim 1, **characterized in that** the repair region (14) extends over the rotor blade running region, the repair region extending, on each side on which the repair region extends beyond the rotor blade region, beyond the rotor blade running region by a maximum of 20%, preferably a maximum of 10%, of the extent of the rotor blade running region in a direction which corresponds to the direction over which the repair region is expanded beyond the rotor blade region.

3. Method according to either of the preceding claims, **characterized in that** a coating (8), provided in the repair region (14), on the base material of the sealing segment is removed before a part of the base material (10) is removed in the repair region.

4. Method according to any of the preceding claims, **characterized in that** material is removed mechanically by grinding and/or milling.

5. Method according to any of the preceding claims, **characterized in that** base material (10) of the sealing segment (9) is removed to the extent that no cracks (13) or pores (12) or only cracks or pores having a diameter or a maximum extent of less than or equal to a limit value according to permissible tolerances of a new sealing segment are contained in the base material in the repair region.

6. Method according to any of the preceding claims, **characterized in that** the repair coating (15) is formed from a repair material which is different from the base material (10) and/or a repair material which is identical to the base material.

7. Method according to any of the preceding claims, **characterized in that** the repair coating (15) consists of a plurality of sub-layers.

8. Method according to any of the preceding claims, **characterized in that** the repair coating (15) is applied by additive manufacturing methods, in particular by deposition welding by means of high-energy beams, in particular laser beams or electron beams.

## Revendications

1. Procédé de réparation de segments d'étanchéité (9) de conception au moins partiellement monocristalline d'une limite de conduit d'écoulement (2) d'une turbomachine, dans lequel on définit d'abord une zone de réparation (14) du segment d'étanchéité qui est définie indépendamment des défaillances (12, 13) présentes sans identifier les défaillances locales, de sorte que la zone de réparation n'est pas limitée à des défaillances individuelles à identifier, dans lequel la zone de réparation (14) est définie par une zone déplacement d'aube mobile du segment d'étanchéité (9), laquelle zone de déplacement est parcourue par une aube mobile (4) de la turbomachine pendant le fonctionnement de ladite turbomachine ou au moins frôlée par ladite aube mobile lors de son extension radiale théorique, **caractérisé en ce qu'**une partie d'un matériau de base (10) du segment d'étanchéité (9) est ensuite extraite de la zone de réparation (14), dans lequel un revêtement de réparation (15) est par la suite déposé par épitaxie dans la zone de réparation, dans lequel le revêtement de réparation (15) est appliqué à l'aide d'une surcote et formé de manière mécanique, notamment par usinage, après l'application.

2. Procédé selon la revendication 1, **caractérisé en ce que** la zone de réparation (14) s'étend sur la zone de déplacement d'aube mobile, dans lequel la zone de réparation de chaque côté où la zone de réparation dépasse la zone de déplacement d'aube mobile dépasse la zone de déplacement d'aube mobile de 20 % maximum, de préférence de 10 % maximum de l'extension de la zone de déplacement d'aube mobile dans une direction correspondant à la direction sur laquelle la zone de réparation est étendue sur la zone de déplacement d'aube mobile.

3. Procédé selon l'une des revendications précédentes, **caractérisé en ce qu'**un revêtement (8) prévu dans la zone de réparation (14) sur le matériau de base du segment d'étanchéité est extrait avant l'extraction d'une partie du matériau de base (10) dans la zone de réparation.

4. Procédé selon l'une des revendications précédentes, **caractérisé en ce que** l'extraction du matériau est effectuée de manière mécanique par ponçage et/ou par fraisage.

5. Procédé selon l'une des revendications précédentes, **caractérisé en ce que** l'extraction du matériau de base (10) du segment d'étanchéité (9) est effectué dans une mesure où, dans la zone de réparation, le matériau de base ne contient pas de fissures (13) ou de pores (12) ou ne contient que des fissures ou des pores dont le diamètre ou l'extension maximale est inférieur(e) ou égal(e) à une valeur limite selon les tolérances admissibles d'un nouveau segment d'étanchéité.

6. Procédé selon l'une des revendications précédentes, **caractérisé en ce que** le revêtement de réparation (15) est constitué d'un matériau de réparation différent du matériau de base (10) et/ou d'un matériau de réparation identique au matériau de base.

7. Procédé selon l'une des revendications précédentes, **caractérisé en ce que** le revêtement de réparation (15) est composé de plusieurs couches partielles.

8. Procédé selon l'une des revendications précédentes, **caractérisé en ce que** le revêtement de réparation (15) est appliqué par des procédés génératifs, en particulier par soudage à superposition au moyen de faisceaux à haute énergie, notamment des faisceaux laser ou des faisceaux d'électrons.
